# EUROPÄISCHE PATENTSCHRIFT

(11) **EP 3 513 633 B1**
(45) Veröffentlichungstag und Bekanntmachung des Hinweises auf die Patenterteilung: **01.09.2021**
(21) Anmeldenummer: 17772002.6
(22) Anmeldetag: 12.09.2017
(51) Int. Cl.: H05K 5/00, H05K 5/02

(54) **GEHÄUSE FÜR EIN STEUERGERÄT UND ABDECKHAUBE FÜR DAS GEHÄUSE**
CASING FOR A CONTROL UNIT AND COVERING HOOD FOR THE CASING
BOÎTIER CONÇU POUR UN APPAREIL DE COMMANDE ET STRUCTURE DE RECOUVREMENT POUR CE BOÎTIER

(30) Priorität: 15.09.2016 DE 102016117330
(43) Veröffentlichungstag der Anmeldung: 24.07.2019
(73) Patentinhaber: KNORR-BREMSE Systeme für Nutzfahrzeuge GmbH, 80809 München (DE)
(72) Erfinder: LECHNER, Klaus, 91362 Pretzfeld (DE); MÜLLER, Elena, 90453 Nürnberg (DE); BEHRENDT, Norbert, 90547 Stein (DE)
(86) Internationale Anmeldenummer: PCT/EP2017/072920
(87) Internationale Veröffentlichungsnummer: WO 2018/050651

(56) Entgegenhaltungen:
- DE-A1-102013 104 305
- US-A1- 2010 300 909
- US-A1- 2014 202 899

## Beschreibung

Die vorliegende Erfindung bezieht sich auf ein Gehäuse für ein Steuergerät und auf eine Abdeckhaube für das Gehäuse und insbesondere auf eine Befestigung einer Abdeckhaube ohne zusätzliche Teile.

Bei Steuergeräten und insbesondere bei solchen Steuergeräten, die in Fahrzeugen (z.B. Nutzfahrzeugen) zum Einsatz kommen, ist es wichtig, dass die Elektronik der Steuergeräte zuverlässig vor Nässe und Verschmutzung geschützt wird. Dazu werden die (elektrischen) Anschlussleitungen durch zusätzliche Abdeckhauben vor den Umwelteinflüssen geschützt und gleichzeitig zuverlässig gehalten. Häufig kommt es jedoch vor, dass nicht nur eine Anschlussleitung an ein Steuergerät befestigt wird, sondern mehrere Anschlussleitungen in einem Anschlussbereich des Steuergerätes zu befestigen sind. Dementsprechend werden häufig mehrere Abdeckhauben genutzt, um die verschiedenen Anschlussleitungen zu schützen und gleichzeitig an dem Steuergerät zu fixieren.

Bei konventionellen Steuergeräten werden entweder unterschiedliche Abdeckhauben genutzt, um verschiedene Abschnitte eines Anschlussbereiches zu schützen, oder aber zusätzliche Befestigungsteile sind erforderlich, um gleiche Abdeckhauben für die verschiedenen Abschnitte zu verwenden. Beispielsweise werden in der US 2014/202899 A1 ein elektronisches Gerät (z. B. Mobiltelefon) mit einer Hülle, in US 2010/300909 A1 ein Gehäuse für ein mobiles Mediengerät und in DE 10 2013 104 305 A1 eine schwenkbare Baugruppe für eine Platine offenbart.

Um die Fertigung der Steuergeräte bzw. der Abdeckhauben effizienter zu gestalten und gleichzeitig den Anschluss der Leitungen zu erleichtern, besteht ein Bedarf danach, gleiche Abdeckhauben für verschiedene Abschnitte eines Anschlussbereiches eines Gehäuses zu nutzen, ohne dass zusätzliche Teile erforderlich sind, um die gleichen Abdeckhauben an verschiedenen Stellen des Steuergerätes anzubringen.

Zumindest einige der obengenannten Probleme werden durch ein Gehäuse nach Anspruch 1 und eine Abdeckhaube nach Anspruch 7 gelöst. Vorteilhafte Weiterverbindungen der Gegenstände der unabhängigen Ansprüche sind durch die Ansprüche 2 bis 6 und 8 bis 15 definiert.

Die vorliegende Erfindung bezieht sich auf ein Gehäuse nach Anspruch 1 für ein Steuergerät. Das Gehäuse umfasst einen Anschlussbereich und vier Greifarme. Der Anschlussbereich befindet sich auf einer Anschlussseite des Gehäuses und ist durch zwei Abdeckhauben verschließbar, wobei jede Abdeckhaube zwei Scharnierelemente umfasst, die entlang einer Kante der Abdeckhaube unsymmetrisch von einer Mitte der Kante angeordnet sind.

Die Greifarme sind ausgebildet, um die Scharnierelemente der beiden Abdeckhauben zumindest teilweise zu umgreifen und drehend zu halten, wobei die zumindest zwei Abdeckhauben (jeweils) an verschiedenen Positionen auf dem Anschlussbereich des Gehäuses aufsetzbar und drehend verschließbar sind.

Das Gehäuse kann optional zwei Verschlusselemente und jede Abdeckhaube kann ein Arretierelement aufweisen, so dass die Arretierelemente der beiden Abdeckhauben die zwei Verschlusselemente in Eingriff nehmen können und dadurch ein Öffnen der Abdeckhauben blockieren.

Der Begriff "Umgreifen" soll im Rahmen der vorliegenden Erfindung nicht so verstanden werden, dass die Greifarme die entsprechenden Scharnierelemente vollständig umgreifen. Vielmehr sollen die Greifarme die Scharnierelemente lediglich soweit umgreifen, um nach dem Aufsetzen und Verdrehen der Abdeckhauben die Abdeckhauben durch die Greifarme an einer Seite zu halten. Ein vollständiger Halt kann beispielsweise erst nach einer Arretierung durch das/die Verschlusselement(e) erreicht werden. Die Verschlusselemente für die Abdeckhauben können Abschnitte des Gehäuses sein, die an unterschiedlichen Positionen angeordnet sind, um die beiden Abdeckhauben zu fixieren.

Die beiden Abdeckhauben, die auf dem Gehäuse aufsetzbar sind, können beispielweise baugleich sein. Optional können sie sich jedoch auch unterscheiden, wobei gemäß Ausführungsbeispielen der vorliegenden Erfindung beide, eventuell unterschiedlich gestaltete Abdeckhauben an beiden Positionen auf dem Anschlussbereich des Gehäuses aufsetzbar sind. Somit sind die beiden Abdeckhauben untereinander vertauschbar und brauchen nicht an einer vorbestimmten Position aufgesetzt zu werden.

Außerdem werden alle zur Fixierung der Abdeckhauben erforderlichen Mittel entweder durch die Abdeckhaube selbst oder durch das Gehäuse oder durch die gegenüberliegend angeordnete Abdeckhaube bereitgestellt. Somit sind keine zusätzlichen Teile oder Elemente erforderlich, um die beiden Abdeckhauben auf dem Gehäuse anzubringen.

Optional kann das Gehäuse einen Unterbau und einen Oberbau aufweisen, wobei in dem Unterbau Elektronikkomponenten angeordnet und in dem Oberbau beispielhaft elektrische (oder auch optische) Anschlussbuchsen vorhanden sind. Die zwei (baugleichen) Abdeckhauben können jeweils eine Seite des Oberbaus öffnen und verschließen, um die Anschlüsse zu schützen bzw. offenzulegen.

Jede Abdeckhaube umfasst jeweils zwei Scharnierelemente, die entlang einer Kante der Abdeckhaube unsymmetrisch von einer Mitte angeordnet sind. Dementsprechend halten zwei Greifarme von den vier Greifarmen eine Abdeckhaube und die zwei anderen Greifarme die andere Abdeckhaube halten und die beiden Abdeckhauben auf der Anschlussseite des Gehäuses um 180° verdreht zueinander angeordnet sind.

Die unsymmetrische Anordnung der Scharnierelemente entlang der Kante der Abdeckhaube ist beispielsweise derart, dass die beiden Scharnierelemente nicht spiegelsymmetrisch entlang einer Mittenlinie der Abdeckhaube ausgebildet sind, sondern dass ein Scharnierelement einen größeren Abstand von der Mittenlinie aufweist als das andere Scharnierelement. Damit wird erreicht, dass zwei Abdeckhauben einander gegenüberliegend (d.h. um 180° verdreht) auf das Gehäuse aufgesetzt werden können, ohne dass die Scharnierelemente sich gegenseitig behindern, sondern vielmehr versetzt zueinander auf dem Gehäuse platziert sind. Beispielsweise sind die Scharnierelemente nach dem Aufsetzen der Abdeckhauben benachbart zueinander angeordnet.

Daher sind bei Ausführungsbeispielen die zumindest zwei Greifarme und das Verschlusselement ausgebildet, um ein Vertauschen der beiden Abdeckhauben auf dem Gehäuse zu ermöglichen.

Optional umfassen die Scharnierelemente jeweils einen stabförmigen Abschnitt, der in einer Querschnittsansicht senkrecht zu einer Drehachse des jeweiligen Scharnierelementes einen abgeflachten Abschnitt aufweist. Dementsprechend kann das Gehäuse optional zumindest zwei Lagerungen umfassen, die ausgebildet sind, um den stabförmigen Abschnitt des jeweiligen Scharnierelementes zu der Anschlussseite des Gehäuses hin abzustützen und drehbar um die Drehachse zu lagern. Die zumindest zwei Greifarme brauchen die stabförmigen Scharnierelemente der beiden Abdeckhauben nur teilweise umgreifen, um in zumindest einer Winkelposition (z.B. senkrecht) relativ zu dem Gehäuse ein Einsetzen oder Entfernen der Abdeckhaube zu ermöglichen, und nach einem Drehen der Abdeckhaube (z.B. um 90°) durch eine formschlüssige Verbindung die Abdeckhaube auf dem Gehäuse zu halten.

Somit stellt ein Drehen der Abdeckhauben relativ zu dem Gehäuse eine formschlüssige Verbindung zwischen der Abdeckhaube und dem Gehäuse her, die für eine bestimmte Winkelposition oder einen bestimmten Winkelbereich gelöst wird (z.B. bei einer senkrechten Stellung der Abdeckhaube relativ zu dem Gehäuse). Dabei ist jede formschlüssige Verbindung möglich. Beispielsweise können die stabförmigen Abschnitte der Scharnierelemente halbrundförmig gebildet sein (d.h. der abgeflachte Abschnitt erstreckt sich entlang des Durchmessers).

Bei weiteren Ausführungsbeispielen sind die zumindest zwei Greifarme (und die zwei Lagerungen) ausgebildet, um die beiden Abdeckhauben, um eine gemeinsame Drehachse drehbar zu halten.

Die vorliegende Erfindung bezieht sich auch auf eine Abdeckhaube für das zuvor beschriebene Gehäuse. Die Abdeckhaube umfasst zumindest ein Scharnierelement, das ausgebildet ist, um durch eines der Greifarme drehend gehalten zu werden (z.B. in einem bestimmten Winkelbereich).

Die Abdeckhaube kann weiter ein Arretierelement umfassen, das ausgebildet ist, um durch ein Koppeln mit dem Verschlusselement des Gehäuses ein Öffnen der Abdeckhaube zu verhindern. Die Kopplung zwischen dem Arretierelement und dem Verschlusselement des Gehäuses blockiert beispielsweise ein Drehen der Abdeckhaube durch ein Einrasten des Arretierelementes in dem Verschlusselement des Gehäuses. Somit wird verhindert, dass die Abdeckhaube in die Winkelposition gelangen kann, in welcher sie von dem Gehäuse entfernt werden kann, so dass die Abdeckhaube auf dem Gehäuse fixiert ist und nicht relativ zum Gehäuse bewegt werden kann.

Bei weiteren Ausführungsbeispielen umfasst das Scharnierelement wie bereits gesagt einen stabförmigen Abschnitt, der in einer Querschnittsansicht senkrecht zu einer Drehachse des Scharnierelementes einen abgeflachten Abschnitt aufweist, um in zumindest einer Winkelposition relativ zum Gehäuse ein Einsetzen oder Entfernen der Abdeckhaube zu ermöglichen (z.B. senkrecht zu der Anschlussseite des Gehäuses), und nach einem Drehen der Abdeckhaube durch eine formschlüssige Verbindung die Abdeckhaube auf dem Gehäuse zu halten. Beispielsweise kann der stabförmige Abschnitt des Scharnierelementes einen halbkreisförmigen Querschnitt senkrecht zur Drehachse aufweisen, wobei der abgeflachte Abschnitt so ausgebildet ist, dass der Greifarm daran vorbeigeführt werden kann und dadurch ein Einsetzen der Abdeckhaube ermöglicht wird.

Bei weiteren Ausführungsbeispielen definiert das Scharnierelement eine Öffnung, in die eines der zumindest zwei Greifarme des Gehäuses einführbar ist, um das Scharnierelement zu umgreifen. Damit wird beispielsweise ein fester Sitz der Abdeckhaube auf dem Gehäuse ermöglich, während (nur) Drehbewegungen möglich bleiben. Ein Verschieben parallel zur Gehäuseoberfläche wird aber verhindert.

Optional umfasst Abdeckhaube zumindest einen Vorsprung, der ausgebildet ist, um ein Scharnierelement von der weiteren Abdeckhaube, die gegenüberliegend zu der Abdeckhaube auf dem Gehäuse angeordnet ist, abzustützen.

Bei weiteren Ausführungsbeispielen umfasst der zumindest eine Vorsprung zwei Vorsprünge, die jeweils einen senkrecht zur Drehachse halbrundförmigen Lagerabschnitt aufweisen, um jeweils ein Scharnierelement von der weiteren Abdeckhaube aufzunehmen und drehend zu lagern.

Optional umfasst das Gehäuse zumindest eine Gehäuseaussparung und ebenso umfasst die Abdeckhaube zumindest eine Aussparung, die nach einem Schließen der Abdeckhaube auf dem Gehäuse mit der Gehäuseaussparung eine Öffnung bildet. Durch diese Öffnung kann eine elektrische Anschlussleitung ins geschlossene Gehäuse eingeführt werden.

Optional umfasst die Abdeckhaube eine seitliche Schürze zum seitlichen Schutz für unterhalb der Abdeckhaube befindlichen elektrischen Anschlüsse.

Bei weiteren Ausführungsbeispielen umfasst das Verschlusselement des Gehäuses ein Rastelement und das Arretierelement ist ein Einrastverschluss, der an dem Rastelement einrastbar ist.

Die vorliegende Erfindung bezieht sich auch auf ein Steuergerät für ein Fahrzeug, insbesondere für ein Nutzfahrzeug, mit einem zuvor beschriebenen Gehäuse und einer ersten und einer zweiten zuvor beschriebenen Abdeckhaube. Außerdem bezieht sich die Erfindung auch auf ein Nutzfahrzeug mit dem Steuergerät.

Ausführungsbeispiele der vorliegenden Erfindung bieten den Vorteil, dass eine kostengünstige und einfache Befestigung von Abdeckhauben auf einem Gehäuse möglich wird. Insbesondere sind keine zusätzlichen Teile zur Fixierung der Abdeckhaube erforderlich. Außerdem können baugleiche oder identische Abdeckhauben genutzt werden, um sie an gegenüberliegenden Positionen auf dem Gehäuse bzw. auf einer Seite des Gehäuses zu befestigen und drehend zu schließen.

Bei der Angabe von Werten oder Bereichsgrenzen wird im Rahmen der vorliegenden Erfindung davon ausgegangen, dass die betreffenden Angaben keine genau einzuhaltenden Größen sind, sondern eine bestimmte Toleranzbreite miterfasst sein soll. Diese Toleranzbreite kann beispielsweise durch Abweichungen von ± 20% oder ± 10% von dem betreffenden Wert definiert werden.

Die Ausführungsbeispiele der vorliegenden Erfindung werden besser verstanden mit der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränkt, sondern lediglich der Erklärung und dem Verständnis dienen.
- Fig. 1: zeigt ein Gehäuse für ein Steuergerät gemäß einem Ausführungsbeispiel der vorliegenden Erfindung.
- Fig. 2: zeigt eine Abdeckhaube für das Gehäuse aus der Fig. 1 gemäß einem Ausführungsbeispiel.
- Fig. 3: zeigt eine Raumansicht des Gehäuses mit aufgesetzten Abdeckhauben.
- Fig. 4: zeigt eine Draufsicht auf das Gehäuse mit geschlossenen Abdeckhauben.
- Fig. 5: veranschaulicht den Prozess des Aufsetzens der Abdeckhaube auf das Gehäuse.

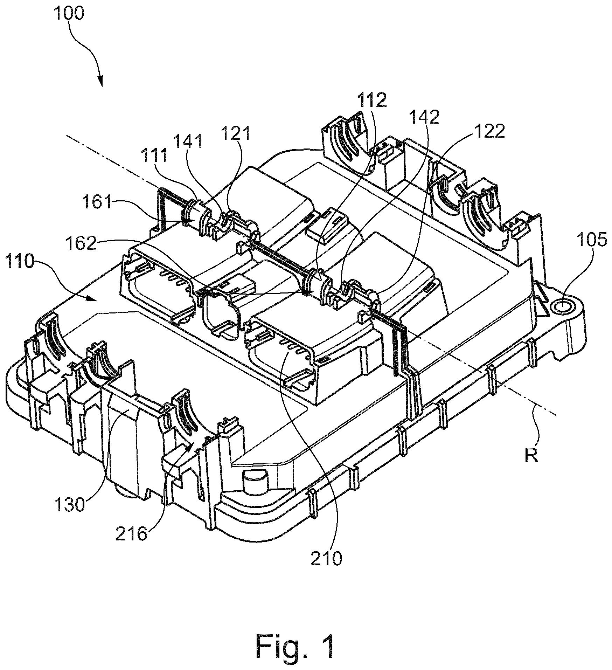

**Fig. 1** zeigt ein Gehäuse 100, welches für ein Steuergerät geeignet ist (beispielsweise in Nutzfahrzeugen). Das Gehäuse 100 umfasst einen Anschlussbereich 110, der beispielsweise auf einer Seite (Anschlussseite, oben in Fig. 1) des Gehäuses 100 ausgebildet ist. Der Anschlussbereich 110 ist durch zwei Abdeckhauben (in der Fig. 1 nicht zu sehen) verschließbar. Zum Verschließen des Anschlussbereiches 110 durch die Abdeckhauben umfasst das Gehäuse beispielsweise vier Greifarme 111, 112, 121, 122. Optional weist das Gehäuse 100 Befestigungsmittel 105 auf, die ein Befestigen des Gehäuses 100, beispielsweise an einem Fahrzeug, ermöglichen (z.B. durch eine Schraubverbindung).

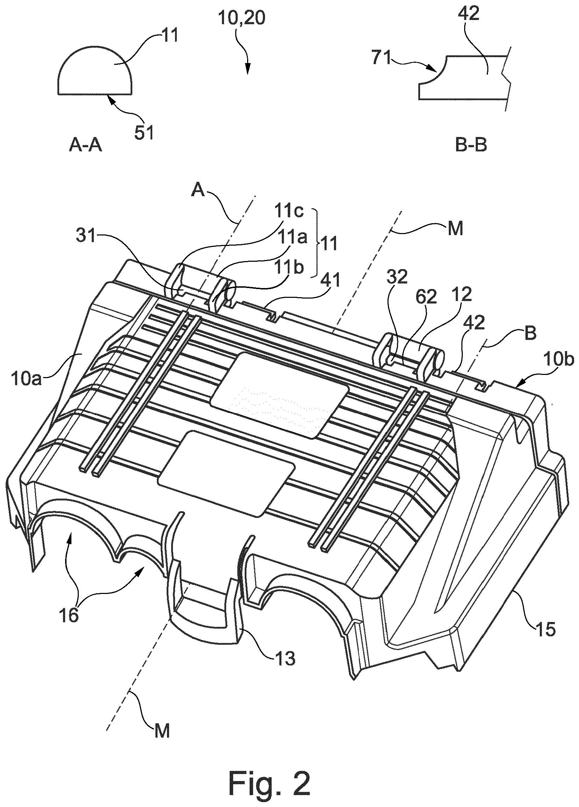

**Fig. 2** zeigt eine der beiden Abdeckhauben 10, 20 die auf dem Gehäuse 100 der Fig. 1 aufsetzbar sind. Die gezeigte Abdeckhaube 10, 20 umfasst zwei Scharnierelemente 11, 12, die ausgebildet sind, um jeweils durch einen Greifarm 111, 112 (oder 121, 122) des Gehäuses 100 aus der Fig. 1 zumindest in einem Winkelbereich drehend gehalten zu werden. Die Greifarme 111, 112 sind ausgebildet, um das zumindest eine Scharnierelement 11, 12 der beiden Abdeckhauben zumindest teilweise zu umgreifen.

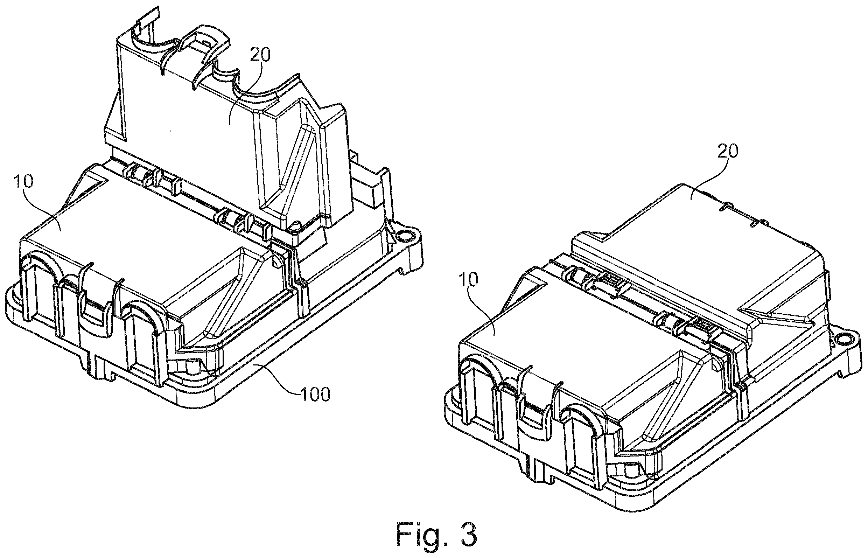

**Fig. 3** zeigt eine Raumansicht des Gehäuses 100, wobei beide Abdeckhauben 10, 20 aufgesetzt sind. Auf der linken Seite ist zunächst der Zustand zu sehen, bei dem eine Abdeckhaube 10 geschlossen und eine weitere Abdeckhaube 20 senkrecht nach oben steht (offener Zustand). Wie im Folgenden detailliert beschrieben wird, erfolgt nach dem Drehen der weiteren Abdeckhaube 20 eine formschlüssige Verbindung zwischen der weiteren Abdeckhaube 20 und der bereits befestigten Abdeckhaube 10 bzw. des Gehäuses 100. Das Resultat ist auf der rechten Seite der Fig. 3 zu sehen.

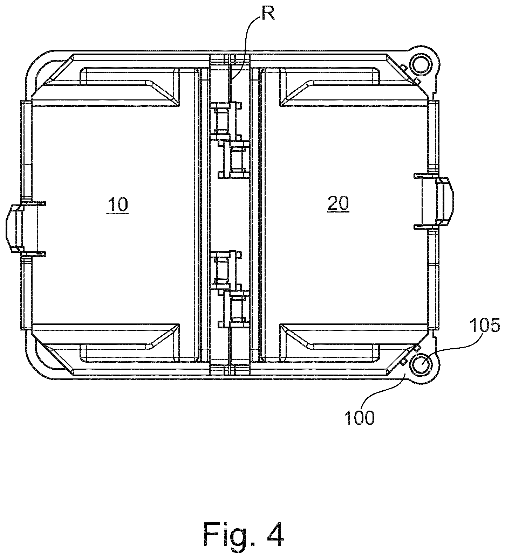

**Fig. 4** zeigt abschließend eine Draufsicht auf das Gehäuse 100 mit den aufgesetzten Abdeckhauben 10, 20.

Das spezielle Ausführungsbeispiel aus der Fig. 1 zeigt beispielhaft ein Gehäuse 100 mit insgesamt vier Greifarmen 111, 121, 112, 122. Zwei der vier Greifarme 111, 112 umgreifen teilweise die Scharnierelemente 11, 12 der ersten Abdeckhaube 10 (siehe Fig. 2 oder 3). Die zwei anderen Greifarme 121, 122 umgreifen teilweise die Scharnierelemente 11, 12 der zweiten Abdeckhaube 20, die um 180° verdreht auf das Gehäuse 100 aufsetzbar ist. Außerdem umfasst das Gehäuse 100 zwei Lagerungen 141, 142, die ausgebildet sind, um die Scharnierelementen 11, 12 der Abdeckhauben 10, 20 in Richtung hin zu dem Gehäuse 100 oder zu dem Anschlussbereich 110 abzustützen. Die vier Greifarme 111, 112, 121, 122 und die zwei Lagerungen 141, 142 sind derart angeordnet, dass die aufsetzbaren Abdeckhauben 10, 20 um eine gemeinsame Drehachse R drehbar gelagert sind.

Die Scharnierelemente 11, 12 definieren beispielsweise Öffnungen 31, 32 (siehe Fig. 2), in die jeweils eines der zumindest zwei Greifarme 111, 112 des Gehäuses 100 einführbar ist, um das Scharnierelement 11, 12 teilweise zu umgreifen. Um eine Führung und/oder einen Halt der Greifarme 111, 112 in den Öffnungen 31, 32 zu verbessern, können die Greifarme 111, 112 vertiefte Bereiche 161, 162 aufweisen (siehe Fig. 1), in die entsprechend gestaltete Vorsprünge, die sich von einem Grundkörper 10a der Abdeckhauben 10, 20 in die Öffnungen 31, 32 hinein erstrecken, eingreifen können. Außerdem können hierdurch die Greifarme 111, 112 seitlich neben den vertieften Abschnitten 161, 162 verstärkt gebildet werden, so dass die Gefahr eines Brechens der Greifarme 111, 112 verringert wird.

Die Erfindung soll jedoch nicht auf die gezeigten vier Greifarme eingeschränkt werden. Bei weiteren Ausführungsbeispiele können auch nur zwei Greifarme vorhanden sein (für jede Abdeckhaube jeweils ein Greifarm). Diese Greifarme können beispielsweise breiter oder an einer anderen Position ausgebildet sein als die Greifarme der Fig. 1, zum Beispiel an Positionen, die nicht symmetrisch zur Mittenlinie M sind (siehe Fig. 2). Beispielsweise könnte sich ein Greifarm über die eine Hälfte des Gehäuses zumindest teilweise erstrecken und der andere Greifarm über die andere Hälfte.

Das Scharnierelement 11 in der Fig. 2 (gleiches gilt für das Scharnierelement 12) umfasst einen stabförmigen Abschnitt 11a, der durch zwei Brückenabschnitte 11b, 11c an einem Grundkörper 10a der Abdeckhaube 10 gehalten wird. Der stabförmige Abschnitt 11a ist in der Fig. 2 oben in der Querschnittsansicht entlang der Linie A gezeigt und umfasst einen abgeflachten Bereich 51, der beispielsweise nach unten ausgerichtet ist (d.h. in Richtung hin zu dem Anschlussbereich 110 des Gehäuses 100 nach dem Aufsetzen der Abdeckhaube 10). Das hat den Effekt, dass die Abdeckhaube in einer senkrechten Position in die Lagerung 141 einsetzbar ist. Der abgeflachte Abschnitt 51 kann auch in eine andere Richtung zeigen, wobei dann die Abdeckhauben 10, 20 in einem anderen Winkel aufzusetzen wären.

Außerdem umfasst die Abdeckhaube 10 zwei Vorsprünge 41, 42, die entlang einer Kante 10b der Abdeckhaube 10 seitlich versetzt neben den Scharnierelementen 11, 12 angeordnet sind. Die Vorsprünge 41, 42 umfassen beispielsweise einen Lagerabschnitt 71, wie er in der Querschnittsansicht entlang der Linie B in der Fig. 2 oben links dargestellt ist. Diese Vorsprünge 41, 42 dienen als Lagerung für die gegenüberliegend angeordnete Abdeckhaube 20, wenn beide Abdeckhauben 10, 20 auf das Gehäuse 100 aus der Fig. 1 aufgesetzt werden. Der Lagerabschnitt 71 ist beispielsweise teilweise rundlich geformt, um einen Halt (oder Abstützung) für die stabförmigen Abschnitte des Scharnierelementes 11, 12 von der gegenüberliegenden Abdeckhaube 20 zu bieten.

In dem gezeigten Ausführungsbeispiel sind beispielhaft mehrere elektrische (oder auch optische) Anschlüsse 210 in dem Anschlussbereich 110 ausgebildet (siehe Fig. 1), die beispielsweise eine Buchse für ein elektrisches Anschlusskabel (nicht gezeigt) darstellen. Außerdem sind Gehäuseaussparungen 216 in dem Gehäuse 100 ausgebildet, die das elektrisches Anschlusskabel zumindest teilweise umschließen, um es fest an dem Gehäuse 100 nach dem Aufbringen der Abdeckhauben 10 zu halten. Die Abdeckhaube aus der Fig. 2 umfasst dazu ebenfalls Aussparungen 16, und zwar an Positionen, so dass nach dem Aufsetzen der Abdeckhaube 10, 20 sich rundliche Öffnungen ergeben, durch die die Anschlusskabel für die elektrische Kontaktierung des beispielhaften Steuergerätes geführt werden können.

Die Abdeckhaube aus der Fig. 2 umfasst weiter eine Schürze 15, die dem Schutz des Anschlussbereiches 110 nach dem Aufsetzen der Abdeckhaube 10, 20 auf das Gehäuse 100 dient (z.B. vor Feuchtigkeit oder Verschmutzung).

Die zwei Abdeckhauben 10, 20 werden an verschiedenen Positionen auf dem Anschlussbereich 110 des Gehäuses 100 aufgesetzt und sind drehend verschließbar. Um die Abdeckhauben 10 zu schließen, umfassen die Abdeckhauben 10, 20 jeweils ein Arretierelement 13, das jeweils in ein Verschlusselement 130 des Gehäuses 100 eingreifen kann, um dadurch die Abdeckhaube 10, 20 auf dem Gehäuse 100 zu verschließen. Ein unbeabsichtigtes Öffnen der Abdeckhaube 10 wird dadurch verhindert.

Das Arretierelement 13 ist beispielsweise ein Einrastverschluss, der federbar mit dem Grundkörper 10a der Abdeckhaube 10 verbunden ist, so dass er sich einrastend mit dem Verschlusselement 130 des Gehäuses 100 verbinden kann. Das Verschlusselement 130 ist beispielsweise als ein Rastelement ausgebildet und umfasst einen abgeschrägten Abschnitt in einer Richtung, in welcher die Abdeckhaube 10, 20 aufgesetzt wird und einen Rastabschnitt, hinter welchem das Arretierelement 13 eingreift, um ein Öffnen der Abdeckhaube 10, 20 nach dem Einrasten zu verhindern. Zum Öffnen der Abdeckhaube 10, 20 ist es daher erforderlich den federbar gelagerten Einrastverschluss 13 von dem Gehäuse 100 wegzudrehen oder wegzuziehen und so die Einrastverbindung zu öffnen. Nach dem Einrasten der Verschlusselemente 130 in die entsprechenden Arretierelemente 13 der Abdeckhauben 10, 20 wird ein Öffnen blockiert.

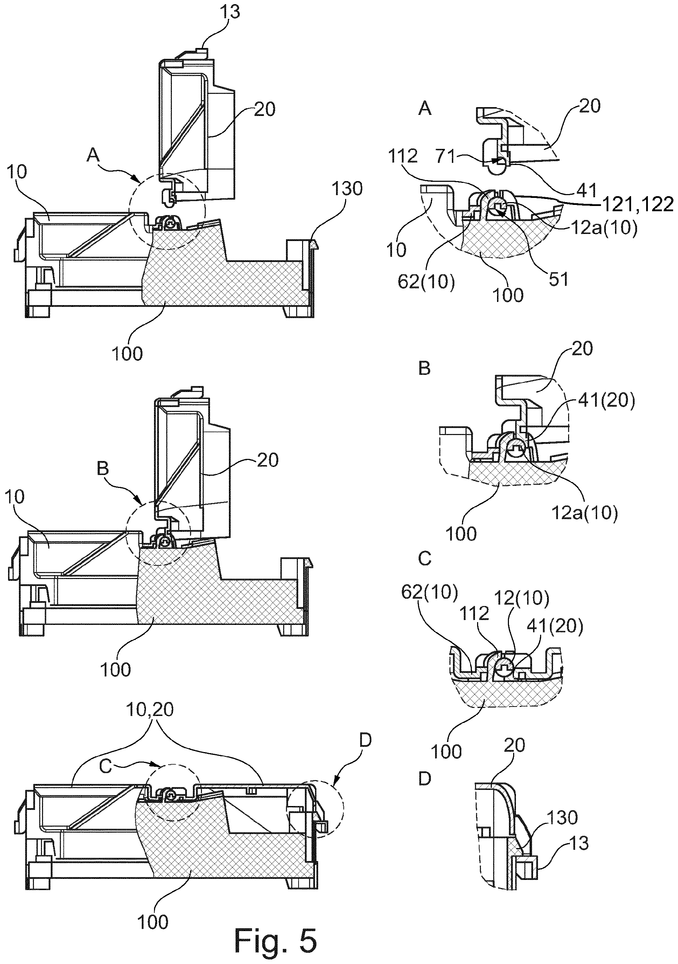

**Fig. 5** veranschaulicht den Prozess des Aufsetzens einer Abdeckhaube 20 auf das Gehäuse 100, wobei in dem gezeigten Ausführungsbeispiel bereits eine Abdeckhaube 10 auf dem Gehäuse 100 aufgesetzt ist. Beide Abdeckhauben 10, 20 können beispielsweise baugleich sein.

In einem Anfangsstadium (siehe oben in der Fig. 5) wird die aufzusetzende Abdeckhaube 20 in einer senkrechten Position relativ zu dem Gehäuse 100 gebracht. In dieser Position (siehe den vergrößerten Abschnitt A der Schnittdarstellung durch den Greifarm 112) ist das Scharnierelement 12 und der Vorsprung 62 der aufgesetzten Abdeckhaube 10 (siehe Fig. 2) durch den Greifarm 112 des Gehäuses 100 fixiert. Gleichzeitig ist in dem vergrößerten Schnitt zu sehen, dass der stabförmige Abschnitt 12a des Scharnierelementes 12 einen abgeflachten Abschnitt 51 aufweist. Dieser abgeflachte Abschnitt 51 ist beispielsweise derart ausgebildet, dass nach einem Drehen der Abdeckhaube 10 in die rechtwinklige Position die Abdeckhaube 10 ebenfalls nach oben entfernt werden kann, da der abgeflachte Abschnitt 51 an die nur teilweise eingreifenden Greifarme 112 vorbeigeführt werden kann.

Bei dem Aufsetzen der weiteren Abdeckhaube 20 stößt der Vorsprung 41 (siehe Fig. 2) mit dem teilweise abgerundeten Lagerabschnitt 71 an das Scharnierelement 12 der Abdeckhaube 10 an. Somit bietet der Lagerabschnitt 71 eine Drehlagerung für den stabförmig gestalteten Abschnitt 12a des Scharnierelementes 12 (siehe Fig. 5, Mitte). Nach dem Aufsetzen und dem Anstoßen des Lagerabschnittes 71 an den stabförmigen Abschnitt 12a der Abdeckhaube 10 kann die Abdeckhaube 20 relativ zu dem Gehäuse 100 gedreht werden, bis sie in dem geschlossenen Zustand (siehe Fig. 5 unten links) gelangt. In dem geschlossenen Zustand greift der Vorsprung 41 unterhalb des Scharnierelementes 12. Gleichzeitig greift das Scharnierelement 11 oder 12 der Abdeckhaube 20 (nicht zu sehen in der Fig. 5) unterhalb der Greifarme 122, 121 des Gehäuses 100, und zwar in der gleichen Weise, wie es für die Abdeckhaube 10 in der Fig. 5 oben zu sehen ist. Als Folge ist auch die Abdeckhaube 20 fest durch das Gehäuse 100 fixiert und kann nicht mehr senkrecht von dem Gehäuse 100 wegbewegt werden. Nach dem Einrasten des Arretierelementes 13 in das Verschlusselement 130 wird auch eine Drehbewegung der Abdeckhaube 20 und somit ein Aufklappen der Abdeckhaube 20 verhindert. Die Abdeckhaube 20 ist daran anschließend auf dem Gehäuse 100 fixiert.

Die in der Beschreibung, den Ansprüchen und den Figuren offenbarten Merkmale der Erfindung können sowohl einzeln als auch in beliebiger Kombination für die Verwirklichung der Erfindung wesentlich sein.

### BEZUGSZEICHENLISTE

- 10,20: Abdeckhauben
- 11,12: Scharnierelemente
- 13: Arretierelement
- 15: Schürze
- 16: Aussparungen an der Abdeckhaube
- 41, 42: Vorsprünge
- 51: abgeflachter Abschnitt
- 61, 62: Anschläge
- 71: (abgerundeter) Lagerabschnitt
- 100: Gehäuse
- 105: Befestigungselemente
- 110: Anschlussbereich
- 130: Verschlusselement
- 161, 162: vertiefte Abschnitte
- 210: elektrische Anschlüsse
- 216: Gehäuseaussparungen
- 111,112,121,122: Greifarme
- 141, 142: Lagerungen
- R: gemeinsame Drehachse.

## Patentansprüche

1. Gehäuse (100) für ein Steuergerät, das Gehäuse umfassend:
- einen Anschlussbereich (110), der sich auf einer Anschlussseite des Gehäuses (100) befindet und durch zwei Abdeckhauben (10, 20) verschließbar ist, wobei jede Abdeckhaube (10, 20) jeweils zwei Scharnierelemente (11, 12) umfasst, die entlang einer Kante (10b) der Abdeckhaube (10, 20) unsymmetrisch von einer Mitte (M) der Kante (10b) angeordnet sind; und
- zumindest vier Greifarme (111, 121), die ausgebildet sind, um die Scharnierelemente (11, 12) der beiden Abdeckhauben (10, 20) zumindest teilweise zu umgreifen und drehend zu halten, wobei die zwei Abdeckhauben (10, 20) an verschiedenen Positionen auf dem Anschlussbereich (110) des Gehäuses (100) aufsetzbar und drehend verschließbar sind.

2. Gehäuse (100) nach Anspruch 1, wobei jede Abdeckhaube (10, 20) jeweils ein Arretierelement (13) umfasst,
**gekennzeichnet durch:**
zwei Verschlusselemente (130), die ausgebildet sind, um die Arretierelemente (13) der beiden Abdeckhauben (10, 20) in Eingriff zu nehmen und dadurch ein Öffnen der Abdeckhauben (10, 20) zu blockieren.

3. Gehäuse (100) nach Anspruch 1 oder Anspruch 2,
**dadurch gekennzeichnet, dass**
die Greifarme (111, 121) und das Verschlusselement (130) ausgebildet sind, um ein Vertauschen der beiden Abdeckhauben (10, 20) auf dem Gehäuse (100) zu ermöglichen.

4. Gehäuse (100) nach einem der vorhergehenden Ansprüche,
**dadurch gekennzeichnet, dass**
von den vier Greifarmen (111, 112, 121, 122)zwei Greifarme (111, 112) eine Abdeckhaube (10) halten und die zwei anderen Greifarme (121, 122) die andere Abdeckhaube (20) halten und die beiden Abdeckhauben (10, 20) auf der Anschlussseite des Gehäuses um 180° verdreht zueinander angeordnet sind.

5. Gehäuse (100) nach einem der vorhergehenden Ansprüche, wobei die Scharnierelemente (11, 12) einen stabförmigen Abschnitt (11a) aufweisen, der in einer Querschnittsansicht senkrecht zu einer Drehachse (R) des Scharnierelementes (11, 12) einen abgeflachten Abschnitt (51) aufweist,
**gekennzeichnet durch:**
- zumindest zwei Lagerungen (141, 142), die ausgebildet sind, um den stabförmigen Abschnitt (11a) des Scharnierelementes (11, 12) zu der Anschlussseite des Gehäuses (100) hin abzustützen und drehbar um die Drehachse (R) zu lagern, wobei die zumindest zwei Greifarme (111, 121) die stabförmigen Scharnierelemente (11, 12) der beiden Abdeckhauben (10, 20) nur teilweise umgreifen, um in zumindest einer Winkelposition relativ zu dem Gehäuse (100) ein Einsetzen oder Entfernen der Abdeckhaube (10) zu ermöglichen, und nach einem Drehen der Abdeckhaube (10, 20) durch eine formschlüssige Verbindung die Abdeckhaube (10) auf dem Gehäuse (100) zu halten.

6. Gehäuse (100) nach einem der vorhergehenden Ansprüche,
**dadurch gekennzeichnet, dass**
die Greifarme (111, 121) ausgebildet sind, um die beiden Abdeckhauben (10, 20) um eine gemeinsame Drehachse (R) drehbar zu halten.

7. Abdeckhaube (10) ausgebildet für ein Gehäuse (100) nach einem der Ansprüche 1 bis 6, die Abdeckhaube umfassend:
- Scharnierelemente (11, 12), die ausgebildet sind, um jeweils durch zwei Greifarme (111, 112) des Gehäuses (100) drehend gehalten zu werden, wobei die Scharnierelemente an der Abdeckhaube entlang einer Kante (10b) der Abdeckhaube unsymmetrisch von einer Mitte (M) der Kante (10b) angeordnet sind.

8. Abdeckhaube (10) nach Anspruch 7,
**dadurch gekennzeichnet, dass**
jedes Scharnierelement (11, 12) einen stabförmigen Abschnitt (11a) aufweist, der in einer Querschnittsansicht senkrecht zu einer Drehachse (R) des Scharnierelementes (11, 12) einen abgeflachten Abschnitt (51) aufweist, um in zumindest einer Winkelposition relativ zu dem Gehäuse (100) ein Einsetzen oder Entfernen der Abdeckhaube (10) zu ermöglichen, und nach einem Drehen der Abdeckhaube (10, 20) durch eine formschlüssige Verbindung die Abdeckhaube (10) auf dem Gehäuse (100) zu halten.

9. Abdeckhaube (10) nach Anspruch 8,
**dadurch gekennzeichnet, dass**
die Scharnierelemente (11, 12) Öffnungen (31, 32) definieren, in die jeweils eines der Greifarme (111, 112) des Gehäuses (100) einführbar sind, um das Scharnierelement (11, 12) teilweise zu umgreifen.

10. Abdeckhaube (10) nach einem der Ansprüche 7 bis 9,
**gekennzeichnet durch**
- zumindest ein Vorsprung (41, 42), der ausgebildet ist, um ein Scharnierelement (11, 12) von einer weiteren Abdeckhaube (20), die gegenüberliegend zu der Abdeckhaube (10) auf dem Gehäuse (100) angeordnet ist, abzustützen.

11. Abdeckhaube (10) nach Anspruch 10,
**dadurch gekennzeichnet, dass**
der zumindest einen Vorsprung (41, 42) zwei Vorsprünge aufweist, die jeweils einen senkrecht zur Drehachse (R) rundförmigen Lagerabschnitt (71) aufweisen, um jeweils ein Scharnierelement (112) von der weiteren Abdeckhaube (20) aufzunehmen und drehend zu lagern.

12. Abdeckhaube (10) nach einem der Ansprüche 7 bis 11, wobei das Verschlusselement (130) des Gehäuses (100) insbesondere ein Rastelement umfasst, **gekennzeichnet durch**
- ein Arretierelement (13), das ausgebildet ist, um durch ein Koppeln mit dem Verschlusselement (130) des Gehäuses (100) ein Öffnen der Abdeckhaube (10) zu verhindern, wobei das Arretierelement (13) insbesondere ein Einrastverschluss ist, der an dem Rastelement (230) einrastbar ist.

13. Abdeckhaube (10) nach einem der Ansprüche 7 bis 12, wobei das Gehäuse (100) nach einem der Ansprüche 1 bis 6 zumindest eine Gehäuseaussparung (216) aufweist,
**gekennzeichnet durch**
- zumindest eine Aussparung (16), die nach einem Schließen der Abdeckhaube (10) mit der Gehäuseaussparung eine Öffnung bildet, um eine Anschlussleitung ins geschlossene Gehäuse (100) einzuführen und Halt zu bieten; und/oder
- eine seitliche Schürze (15) zum seitlichen Schutz für die Anschlussleitung unterhalb der Abdeckhaube (10).

14. Steuergerät für ein Fahrzeug, insbesondere für ein Nutzfahrzeug, **gekennzeichnet durch:**
ein Gehäuse (100) nach einem der Ansprüche 1 bis 6;
eine erste Abdeckhaube (10) nach einem der Ansprüche 7 bis 13; und
eine zweite Abdeckhaube (20) nach einem der Ansprüche 7 bis 13.

15. Nutzfahrzeug mit einem Steuergerät nach Anspruch 14.

## Claims

1. Casing (100) for a control unit,
the casing comprising:
- a connector region (110) which is situated on a connector side of the casing (100) and can be closed by way of two covering hoods (10, 20), each covering hood (10, 20) comprising two hinge elements (11, 12) which are arranged along an edge (10b) of the covering hood (10, 20) asymmetrically from a centre (M) of the edge (10b); and
- at least four gripping arms (111, 121) which are configured to at least partially engage around the hinge elements (11, 12) of the two covering hoods (10, 20) and to hold them rotationally, it being possible for the two covering hoods (10, 20) to be placed at different positions on the connector region (110) of the casing (100) and to be closed rotationally.

2. Casing (100) according to claim 1, each covering hood (10, 20) comprising in each case one locking element (13),
**characterised by**:
two closure elements (130) which are configured to engage around the locking elements (13) of the two covering hoods (10, 20) and to block opening of the covering hoods (10, 20) as a result.

3. Casing (100) according to claim 1 or claim 2,
**characterised in that**
the gripping arms (111, 121) and the closure element (130) are configured to make swapping of the two covering hoods (10, 20) on the casing (100) possible.

4. Casing (100) according to one of the preceding claims,
**characterised in that**
of the four gripping arms (111, 112, 121, 122) two gripping arms (111, 112) hold a covering hood (10) and the other two gripping arms (121, 122) hold the other covering hood (20), and the two covering hoods (10, 20) are arranged rotated by 180° with respect to one another on the connector side of the casing.

5. Casing (100) according to one of the preceding claims, the hinge elements (11, 12) having a rod-shaped section (11a) which has a flattened section (51) in a cross-sectional view perpendicularly with respect to a rotational axis (R) of the hinge elements (11, 12),
**characterised by**:
- at least two bearings (141, 142) which are configured to support the rod-shaped section (11a) of the hinge element (11, 12) towards the connector side of the casing (100) and to mount it such that it can be rotated about the rotational axis (R), the at least two gripping arms (111, 121) engaging only partially around the rod-shaped hinge elements (11, 12) of the two covering hoods (10, 20), in order to make an insertion or removal of the covering hood (10) possible in at least one angular position relative to the casing (100), and to hold the covering hood (10) on the casing (100) by way of a positively locking connection after a rotation of the covering hood (10, 20).

6. Casing (100) according to one of the preceding claims,
**characterised in that**
the gripping arms (111, 121) are configured to hold the two covering hoods (10, 20) such that they can be rotated about a common rotational axis (R).

7. Covering hood (10) configured for a casing (100) according to one of claims 1 to 6,
the covering hood comprising:
- hinge elements (11, 12) which are configured to be held rotationally by way of two gripping arms (111, 112) of the casing (100) in each case, the hinge elements being arranged on the covering hood along an edge (10b) of the covering hood asymmetrically from a centre (M) of the edge (10b);

8. Covering hood (10) according to claim 7,
**characterised in that**
each hinge element (11, 12) has a rod-shaped section (11a) which has a flattened section (51) in a cross-sectional view perpendicularly with respect to a rotational axis (R) of the hinge element (11, 12), in order to make an insertion or removal of the covering hood (10) possible in at least one angular position relative to the casing (100), and to hold the covering hood (10) on the casing (100) by way of a positively locking connection after a rotation of the covering hood (10, 20).

9. Covering hood (10) according to claim 8,
**characterised in that**
the hinge elements (11, 12) define openings (31, 32), into which in each case one of the gripping arms (111, 112) of the casing (100) can be introduced, in order to engage partially around the hinge element (11, 12).

10. Covering hood (10) according to one of claims 7 to 9,
**characterised by**
- at least one projection (41, 42) which is configured to support a hinge element (11, 12) of a further covering hood (20) which is arranged on the casing (100) so as to lie opposite the covering hood (10).

11. Covering hood (10) according to claim 10,
**characterised in that**
the at least one projection (41, 42) has two projections which in each case have a bearing section (71) which is round perpendicularly with respect to the rotational axis (R), in order to receive in each case one hinge element (112) of the further covering hood (20) and to mount it rotationally.

12. Covering hood (10) according to one of claims 7 to 11, the closure element (130) of the casing (100) comprising, in particular, a latching element,
**characterised by**
- a locking element (13) which is configured to prevent opening of the covering hood (10) by way of coupling to the closure element (130) of the casing (100), the locking element (13) being, in particular, a latching closure which can be latched on the latching element (230).

13. Covering hood (10) according to one of claims 7 to 12, the casing (100) according to one of claims 1 to 6 having at least one casing cutout (216), **characterised by**
- at least one cutout (16) which forms an opening with the casing cutout after closure of the covering hood (10), in order to introduce a connector line into the closed casing (100) and to grip it; and/or
- a lateral apron (15) for lateral protection for the connector line below the covering hood (10).

14. Control unit for a vehicle, in particular for a commercial vehicle, **characterised by**:
a casing (100) according to one of claims 1 to 6;
a first covering hood (10) according to one of claims 7 to 13; and
a second covering hood (20) according to one of claims 7 to 13.

15. Commercial vehicle having a control unit according to claim 14.

## Revendications

1. Boîtier (100) d'un appareil de commande,
le boîtier comprenant :
- une partie (110) de raccordement, qui se trouve d'un côté de raccordement du boîtier (100) et qui peut être fermée par deux coiffes (10, 20) de recouvrement, dans lequel chaque coiffe (10, 20) de recouvrement comprend respectivement deux éléments (11, 12) de charnière, qui sont disposés le long d'un bord (10b) de la coiffe (10, 20) de recouvrement dissymétriquement par rapport à un milieu (M) du bord (10b) ; et
- au moins quatre bras (111, 121) de préhension, qui sont constitués pour prendre au moins en partie et maintenir tournants les éléments (11, 12) de charnière des deux coiffes (10, 20) de recouvrement, les deux coiffes (10, 20) de recouvrement pouvant être mises et pouvant être fermées en tournant en des positions différentes sur la partie (110) de raccordement du boîtier (100).

2. Boîtier (100) suivant la revendication 1, dans lequel chaque coiffe (10, 20) de recouvrement comprend respectivement un élément (13) d'arrêt,
**caractérisé par** :
deux éléments (130) de fermeture, qui sont constitués pour prendre en prise les éléments (13) d'arrêt des deux coiffes (10, 20) de recouvrement et bloquer ainsi une ouverture des coiffes (10, 20) de recouvrement.

3. Boîtier (100) suivant la revendication 1 ou revendication 2, **caractérisé en ce que**
les bras (111, 121) de préhension et l'élément (130) de fermeture sont constitués pour permettre un remplacement des deux coiffes (10, 20) de recouvrement sur le boîtier (100).

4. Boîtier (100) suivant l'une des revendications précédentes, **caractérisé en ce que**
des quatre bras (111, 112, 121, 122) de préhension, deux bras (111, 112) maintiennent une coiffe (10) de recouvrement et les deux autres bras (121, 122) de préhension maintiennent l'autre coiffe (20) de recouvrement et les deux coiffes (10, 20) de recouvrement sont montées tournées à 180° l'une par rapport à l'autre du côté de raccordement du boîtier.

5. Boîtier (100) suivant l'une des revendications précédentes, dans lequel les éléments (11, 12) de charnière ont un segment (11a) en forme de barrette qui a, dans une vue en section transversale perpendiculairement à un axe (R) de rotation de l'élément (11, 12) de charnière, un segment (51) aplati, **caractérisé par** :
- au moins deux paliers (141, 142) qui sont constitués pour soutenir le segment (11a) en forme de barrette de l'élément (11, 12) de charnière vers le côté de raccordement du boîtier (100) et le monter tournant autour de l'axe (R) de rotation, dans lequel les au moins deux bras (111, 121) de préhension prennent au moins en partie les éléments (11, 12) de charnière en forme de barrette des deux coiffes (10, 20) de recouvrement pour permettre dans au moins une position angulaire par rapport au boîtier (100) d'insérer ou de retirer la coiffe (10) de recouvrement et, après une rotation de la coiffe (10, 20) de recouvrement, de maintenir par une liaison à complémentarité de forme la coiffe (10) de recouvrement sur le boîtier (100).

6. Boîtier (100) suivant l'une des revendications précédentes, **caractérisé en ce que**
les bras (111, 121) de préhension sont constitués pour maintenir tournantes autour d'un axe (R) de rotation commun les deux coiffes (10, 20) de recouvrement.

7. Coiffe (10) de recouvrement constituée pour un boîtier (100) suivant l'une des revendications 1 à 6,
la coiffe de recouvrement comprenant :
- les éléments (11, 12) de charnière, qui sont constitués pour être maintenus tournants respectivement par deux bras (111, 112) de préhension du boîtier (100), les éléments de charnière étant disposés sur la coiffe de recouvrement le long d'un bord (10b) de la coiffe de recouvrement dissymétriquement par rapport à un milieu (M) du bord (10b).

8. Coiffe (10) de recouvrement constituée pour un boîtier (100) suivant la revendication 7,
**caractérisée en ce que**
chaque élément (11, 12) de charnière a un segment (11a) en forme de barrette, qui, dans une vue en section transversale perpendiculairement à un axe (R) de rotation de l'élément (11, 12) de charnière, a un segment (51) aplati afin de rendre possible et d'insérer ou de retirer la coiffe (10) de recouvrement dans au moins une position angulaire par rapport au boîtier (100) et, après une rotation de la coiffe (19) de recouvrement, de maintenir par une liaison à complémentarité de forme la coiffe (10) de recouvrement sur le boîtier (100).

9. Coiffe (10) de recouvrement suivant la revendication 8, **caractérisée en ce que**
les éléments (11, 12) de charnière définissent les ouvertures (31, 32), dans lesquelles respectivement l'un des bras (111, 112) de préhension du boîtier (100) peut être introduit pour prendre au moins en partie l'élément (11, 12) de charnière.

10. Coiffe (10) de recouvrement suivant l'une des revendications 7 à 9,
**caractérisée par**
- au moins une saillie (41, 42) qui est constituée pour soutenir un élément (11, 12) de charnière par une autre coiffe (20) de recouvrement qui est montée sur le boîtier (100) à l'opposé de la coiffe (10) de recouvrement.

11. Coiffe (10) de recouvrement suivant la revendication 10, **caractérisée en ce que**
la au moins une saillie (41, 42) a deux saillies, qui ont chacune une partie (71) formant palier de forme circulaire perpendiculairement à l'axe (R) de rotation, pour recevoir par l'autre coiffe (20) de recouvrement et monter tournant respectivement un élément (112) de charnière.

12. Coiffe (10) de recouvrement suivant l'une des revendications 7 à 11, dans lequel l'élément (130) de fermeture du boîtier (100) comprend notamment un élément d'encliquetage,
**caractérisée par**
- un élément (13) d'arrêt, qui est constitué pour empêcher par un accouplement avec l'élément (130) de fermeture du boîtier (100) une ouverture de la coiffe (10) de recouvrement, l'élément (13) d'arrêt étant notamment une fermeture d'encliquetage, qui peut s'encliqueter sur l'élément (230) d'encliquetage.

13. Coiffe (10) de recouvrement suivant l'une des revendications 7 à 12, dans lequel le boîtier (100) suivant l'une des revendications 1 à 6 a au moins un évidement (216) de boîtier, **caractérisée par**
- au moins un évidement (16), qui après la fermeture de la coiffe (10) de recouvrement, forme avec l'évidement du boîtier une ouverture afin d'introduire une ligne de raccordement dans le boîtier (100) fermé et lui offrir un maintien ; et/ou
- une jupe (15) latérale pour la protection latérale de la ligne de raccordement en-dessous de la coiffe (10) de recouvrement.

14. Appareil de commande d'un véhicule, notamment d'un véhicule utilitaire,
**caractérisé par** :
un boîtier (100) suivant l'une des revendications 1 à 6 ;
une première coiffe (10) de recouvrement suivant l'une des revendications 7 à 13 ; et
une deuxième coiffe (20) de recouvrement suivant l'une des revendications 7 à 13.

15. Véhicule utilitaire ayant un appareil de commande suivant la revendication 14.
